# EUROPÄISCHE PATENTSCHRIFT

(11) **EP 0 928 517 B1**
(45) Veröffentlichungstag und Bekanntmachung des Hinweises auf die Patenterteilung: **04.10.2001**
(21) Anmeldenummer: 97935442.0
(22) Anmeldetag: 21.07.1997
(51) Int. Cl.: H03H 1/00

(54) **KOAXIALES DURCHFÜHRUNGSFILTER**
COAXIAL BUSHING FILTER
FILTRE COAXIAL DE TRAVERSEE

(30) Priorität: 27.09.1996 DE 19639879
(43) Veröffentlichungstag der Anmeldung: 14.07.1999
(73) Patentinhaber: EPCOS AG, 81541 München (DE)
(72) Erfinder: GÖTT, Achim, D-89520 Heidenheim (DE)
(74) Vertreter: Epping, Wilhelm, Dipl.-Ing.
(86) Internationale Anmeldenummer: DE9701529
(87) Internationale Veröffentlichungsnummer: WO9813930

(56) Entgegenhaltungen:
- EP-A- 0 452 643
- EP-A- 0 691 737

## Beschreibung

Die Erfindung betrifft ein koaxiales Durchführungsfilter in π-Schaltung mit zwei kapazitiven Quergliedern und einem ferromagnetischen Längsglied, bei dem die kapazitiven Glieder aus Wickelkondensatoren bestehen, die zusammen mit dem ferromagnetischen Glied auf einem Durchführungsleiter angeordnet sind, bei dem das ferromagnetische Längsglied innerhalb des Kondensatorwickels angeordnet ist, und bei dem die Wickelkondensatoren Stirnkontaktschichten aufweisen.

Durchführungsfilter sind für die breitbandige Entstörung von zum Beispiel Starkstrombetriebsmitteln vorgesehen.

Die in π-schaltung aufgebauten Filter bestehen aus zwei gleichen kapazitiven Quergliedern und einem ferromagnetischen Längsglied. Zur Erzielung ausreichend hoher Dämpfungswerte muß mindestens ein Belag konzentrisch angeordnet sein.

Ein Filter der eingangs genannten Art ist aus der EP 0 691 737 A1 bekannt. Hierbei sind die kapazitiven Querglieder in Form von zwei einzelnen, konzentrisch übereinander angeordneten Teilwickeln ausgeführt, die durch Trennlagen voneinander getrennt sind. Die Wickelstirnseiten werden je nach Aufbau durch mindestens drei Lötstellen mit dem Gehäuse und dem Durchführungsbolzen verbunden. Zur Realisierung der π-Schaltung ist zwischen den Kontaktstellen der Wickelstirnseicen das ferromagnetische Längsglied eingebaut. Jeweils eine der Wickelstirnseiten ist mit dem Gehäuse verbunden. Leitungsgebundene Störungen werden somit über das Gehäuse und eine Schirmwand der zu entstörenden Anlage abgeleitet.

Die Herstellung des bekannten Filters erfordert mehrere Anwickelvorgänge zum Einwickeln der Trennlagen und Wickeln der zweiten Teilkapazität. Außerdem müssen die Rückstände der durch Flammspritzen erzeugten Stirnkontaktschichten wieder von den Trennlagen entfernt werden.

Aufgabe der vorliegenden Erfindung ist es, ein koaxiales Durchführungsfilter der eingangs genannten Art anzugeben, das in einfacher und kostengünstiger Art hergestellt werden kann.

Diese Aufgabe wird erfindungsgemäß dadurch gelöst, daß die kapazitiven Querglieder in Form eines einzigen als Doppelkondensator ausgebildeten Kondensatorwickels ausgeführt sind, welcher aus einer ersten, segmentiert bedampften, und einer zweiten, mit Ausnahme eines Freirandes durchgehend bedampften, Kunststoffolie besteht, daß die Stirnkontaktschicht, die den aus Einzelsegmenten bestehenden Belag kontaktiert in zwei Einzeischichten aufgeteilt ist, und daß die Stirnkontaktschicht, die den durchgehend bedampften Belag kontaktiert nicht geteilt ist.

Vorteilhafte Ausgestaltungen des Gegenstandes der Erfindung sind in den Unteransprüchen angeführt.

Die Erfindung wird im folgenden anhand von Ausführungsbeispielen erläutert.

In der dazugehörenden Zeichnung zeigen:
Fig.1 Eine Metallisierungsanordnung,
Fig.2 und Fig.3 eine Anordnung der Stirnkontaktschichten,
Fig.4 eine weitere Anordnung von Stirnkontaktschichten,
Fig.5 ein Filter und
Fig.6 bis Fig.8 weitere Ausgestaltungen eines Filters.

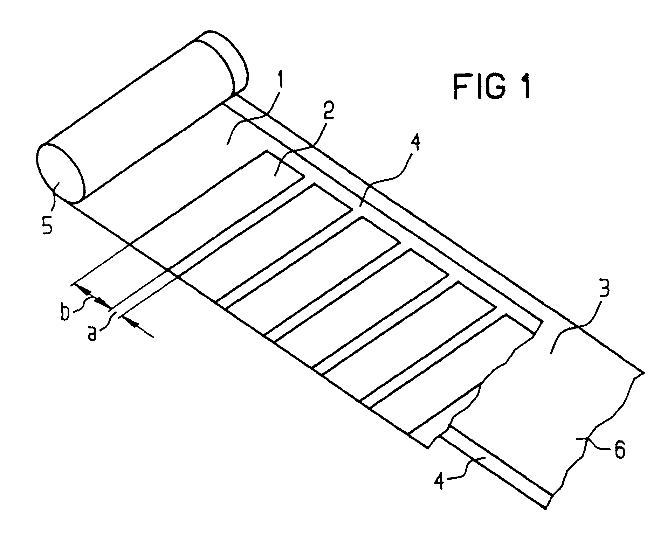

In der Fig.1 ist ein Kondensatorwickel 5 in teilweise aufgerollter Form dargestellt, der aus zwei miteinander verwickelten Kunststoffolien 1, 3 besteht. Die Teilkapazitäten werden durch eine segmentierte Bedampfung auf der Folie 1 erhalten, welche aus Segmenten 2 der Breite b besteht, die mit einem Abstand a voneinander angeordnet sind. Die Größe der Segmente 2 ist dabei derart bemessen, daß an einer Seite der Folie 1 ein Freirand 4 erhalten wird. Die zweite Folie 3 ist mit einer bis auf einen Freirand 4 durchgehenden Metallisierung 6 versehen.

Nach dem vollständigen Aufwickeln des Kondensatorwickels 5 werden die beiden Stirnseiten mit Stirnkontaktschichten versehen, die beispielsweise mittels des bekannten Schoopschen Flammspritzverfahrens hergestellt sind.

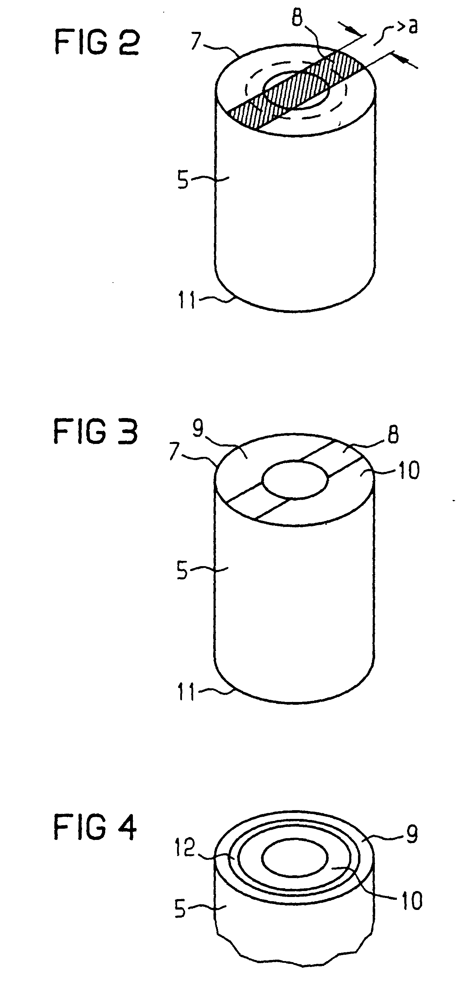

In Fig. 2 ist dargestellt, wie die beiden Teilkapazitäten des koaxialen Durchführungsfilters dadurch hergestellt werden, daß beim Herstellen der Stirnkontaktschicht, mit welcher die Segmente 2 kontaktiert werden, an der Wickelstirnseite 7 ein Streifen 8 mit einer Breite >a abgedeckt wird. An der Wickelstirnseite 11, an der die durchgehende Metallisierung 6 mit einer Stirnkontaktschicht versehen wird, erfolgt keine Abdeckung, so daß der gemeinsame Pol des π-Gliedes an dieser Stirnseite 11 erfolgen kann.

In der Fig. 3 ist der fertige Kondensatorwickel 5 dargestellt, der an der Wickelstirnseite 7 eine geteilte Kontaktschicht mit den Teilflächen 9, 10 aufweist.

In der Fig. 4 ist eine weitere Möglichkeit einer Aufteilung einer Stirnkontaktschicht in zwei konzentrisch angeordnete Teilschichten 9, 10 dargestellt, die durch einen metallfreien Bereich 12 voneinander getrennt sind.

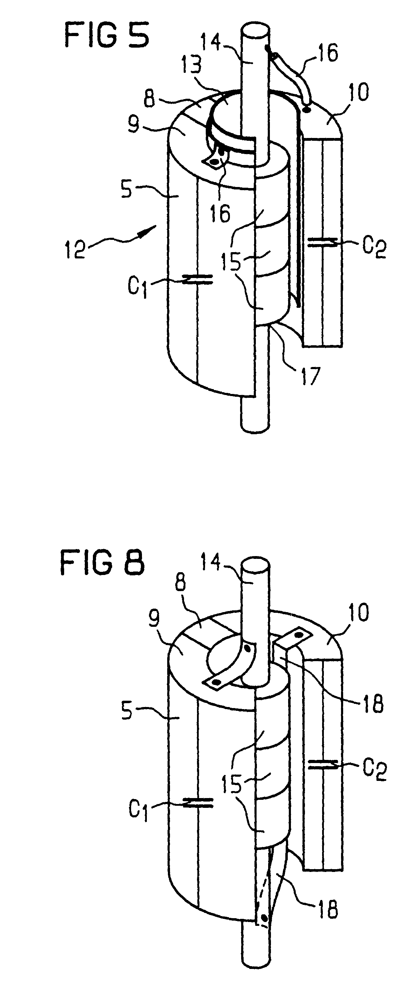

In Fig. 5 ist ein fertiges koaxiales Durchführungsfilter 12 in teilweise aufgeschnittener Ansicht dargestellt. Der Kondensatorwickel 5 mit den beiden Teilkapazitäten C₁, C₂ ist auf ein metallisches Kernrohr 13 aufgewickelt. Im Inneren des Kernrohrs 13 ist der metallische Durchführungsleiter 14 angeordnet auf welchem sich das ferromagnetische Längsglied, zum Beispiel in Form von drei Rohrkernen 15, befindet.

Das metallische Kernrohr 13 ist gegenüber dem Wickel 5 isoliert. Diese Isolierung kann beispielsweise dadurch erfolgen, daß die Metallisierungen 2, 6 von den innen gelegenen Windungen der Kunststoffolien 1, 3 entfernt wird. Es ist aber auch möglich, eine isolierende Folie zwischen Wickel 5 und Kernrohr 13 anzuordnen.

Das metallische Kernrohr 13 kann direkt zur Kontaktierung einer Teilkapazität C₁ mit dem Durchführungsleiter 14 verwendet werden. Hierzu erfolgt eine elektrische Verbindung einerseits durch einen Verbindungsleiter 16, der mit der Kontaktschicht 9 und dem Kernrohr 13 elektrisch leitend verbunden ist, während andererseits das Kernrohr 13 mit dem Durchführungsleiter 14 an der Lötstelle 17 verbunden ist. Die elektrische Verbindung zwischen Teilkapazität C₂ und dem Durchführungsleiter 14 erfolgt über einen weiteren Verbindungsleiter 16, der mit der Kontaktschicht 10 verbunden ist.

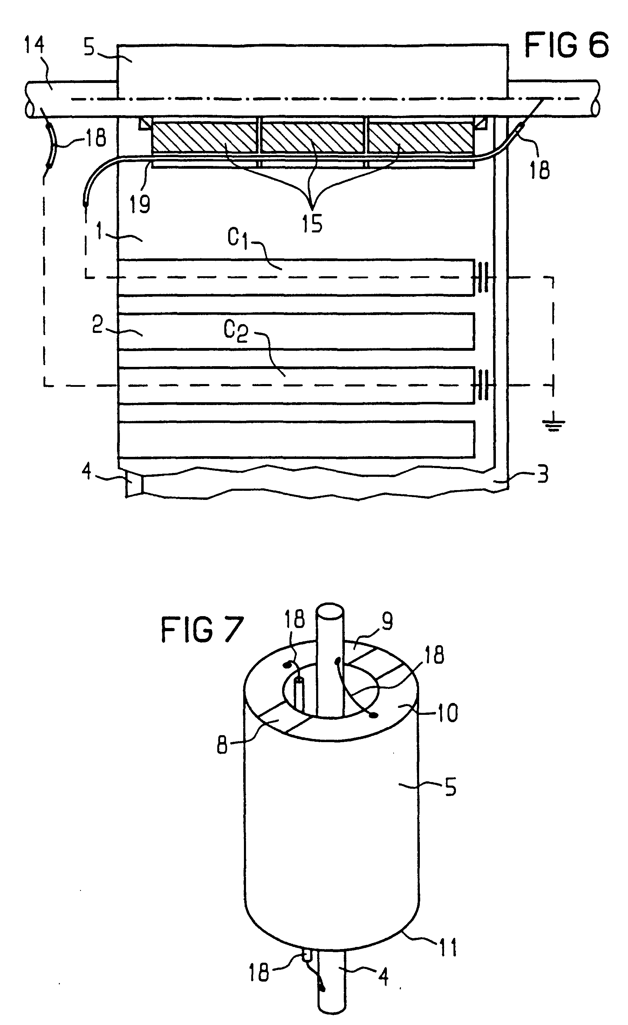

Eine weitere Ausführungsform eines koaxialen Durchführungsfilters ist in Fig.6 dargestellt. Hierbei ist der Kondensatorwickel 5 direkt auf die als Kernrohr dienenden Rohrkerne 15 aufgewickelt. Die Isolierung zwischen Wickel 5 und ferromagnetischem Längsglied kann wieder wie beim in Fig. 5 dargestellten Ausführungsbeispiel durch Demetallisierung der Anfangswindungen beziehungsweise durch eine Isolierlage erfolgen. Die Verbindung zwischen den Teilkapazitäten und dem Durchführungsleiter erfolgt durch metallische Verbindungsleiter 18, die in Form von Drähten oder Streifen ausgeführt sind. Je nach Geometrie des ferromagnetischen Längsgliedes können die Verbindungsleiter 18 in der Bohrung der Rohrkerne 15 oder in einer separat angeordneten Nut 19 geführt werden.

In der Fig.7 ist das in Fig.6 teilweise aufgerollte koaxiale Durchführungsfilter als fertiges Bauteil dargestellt.

In der Fig.8 ist eine Ausführungsform eines koaxialen Durchführungsfilters dargestellt, bei der einer der streifenförmig ausgebildeten Verbindungsleiter 18 zwischen Rohrkernen 15 und isoliertem Wickel 5 eingewickelt ist.

Der Wickel 5 läßt sich so einfach wie ein Standard-Einzelwickel herstellen, bietet aber die Funktionalität eines aufwendiger herstellbaren Trennlagenwickels wie beim eingangs genannten Stand der Technik. Gegenüber dem Stand der Technik entfällt die Trennlage zwischen den Einzelwickeln, sowie die Wickelvorgänge für das Einwickeln der Trennlage und das Anwickeln Belagträger für die zweite Teilkapazität. Ferner ist das Entfernen von Rückständen des Flammspritzens von Trennlagen nicht mehr erforderlich, da keine Trennlagen vorhanden sind. Schließlich entfällt beim Wickeln direkt auf das ferromagnetische Längsglied (Rohrkerne) auch das Kernrohr.

## Patentansprüche

1. Koaxiales Durchführungsfilter (12) in π-schaltung mit zwei kapazitiven Quergliedern (C₁, C₂) und einem ferromagnetischen Längsglied (15), bei dem die kapazitiven Glieder (C₁, C₂) aus Wickelkondensatoren (5) bestehen, die zusammen mit dem ferromagnetischen Glied (15) auf einem Durchführungsleiter (14) angeordnet sind, bei dem das ferromagnetische Längsglied (15) innerhalb des Kondensatorwickels (5) angeordnet ist, und bei dem die Wickelkondensatoren (5) Stirnkontaktschichten (9, 10) aufweisen,
**dadurch gekennzeichnet,**
**daß** die kapazitiven Querglieder in Form eines einzigen als Doppelkondensator ausgebildeten Kondensatorwickels (5) ausgeführt sind, welcher aus einer ersten (1), segmentiert bedampften, und einer zweiten (3), mit Ausnahme eines Freirandes (4) durchgehend bedampften, Kunststoffolie besteht, daß die Stirnkontaktschicht, die den aus Einzelsegmenten (2) bestehenden Belag kontaktiert in zwei Einzelschichten (9, 10) aufgeteilt ist, und daß die Stirnkontaktschicht, die den durchgehend bedampften Belag (6) kontaktiert nicht geteilt ist.

2. Koaxiales Durchführungsfilter nach Anspruch 1,
**dadurch gekennzeichnet,**
**daß** der Kondensatorwickel (5) auf einem metallischen Kernrohr (13) angeordnet ist, und daß die Kontaktierung einer Teilkapazität mit dem Durchführungsleiter (14) über das Kernrohr (13) erfolgt.

3. Koaxiales Durchführungsfilter nach Anspruch 2,
**dadurch gekennzeichnet,**
**daß** das Kernrohr (13) gegen den Kondersatorwickel (5) isoliert ist.

4. Koaxiales Durchführungsfilter nach Anspruch 1,
**dadurch gekennzeichnet,**
**daß** das Kernrohr durch das aus Rohrkernen (15) gebildete ferromagnetische Längsglied gebildet ist.

5. Koaxiales Durchführungsfilter nach Anspruch 4,
**dadurch gekennzeichnet,**
**daß** das ferromagnetische Längsglied gegen den Kondensatorwickel (5) isoliert ist.

6. Koaxiales Durchführungsfilter nach Anspruch 4 oder 5,
**dadurch gekennzeichnet,**
**daß** die Kontaktierung der Teilkapazitäten mit dem Durchführungsleiter (14) über metallische Verbindungsleiter (16, 18) hergestellt ist.

7. Koaxiales Durchführungsfilter nach Anspruch 6,
**dadurch gekennzeichnet,**
**daß** die Verbindungsleiter (16, 18) als Drähte oder Streifenleiter ausgebildet sind.

8. Koaxiales Durchführungsfilter nach Anspruch 6 oder 7,
**dadurch gekennzeichnet,**
**daß** die Verbindungsleiter (16, 18) in der Bohrung der Rohrkerne angeordnet sind.

9. Koaxiales Durchführungsfilter nach Anspruch 6 oder 7,
**dadurch gekennzeichnet,**
**daß** die Verbindungsleiter (16, 18) in einer separaten Nut (19) angeordnet sind.

10. Koaxiales Durchführungsfilter nach Anspruch 6 oder 7,
**dadurch gekennzeichnet,**
**daß** die als Streifenleitung ausgebildeten Verbindungsleiter (18) zwischen Isolierung und ferromagnetischem Längsglied eingewickelt sind.

## Claims

1. Coaxial bushing filter (12) in a π circuit having two capacitive parallel elements (C₁, C₂) and a ferromagnetic series element (15), in which the capacitive elements (C₁, C₂) comprise wound capacitors (5) which are arranged together with the ferromagnetic element (15) on a bushing conductor (14), in which the ferromagnetic series element (15) is arranged within the capacitor winding (5), and in which the wound capacitors (5) have end contact layers (9, 10),
**characterized**
**in that** the capacitive parallel elements are in the form of a single capacitor winding (5), which is in the form of a double capacitor and comprises a first (1) plastic film vapour-deposited in segments, and a second (3) plastic film, vapour-deposited continuously with the exception of a free edge (4), in that the end contact layer, which makes contact with the plate comprising individual segments (2) is split into two individual layers (9, 10), and in that the end contact layer which makes contact with the plate (6) that is vapour-deposited continuously is not split.

2. Coaxial bushing filter according to Claim 1,
**characterized**
**in that** the capacitor winding (5) is arranged on a metallic core tube (13), and in that contact is made between a capacitance element and the bushing conductor (14) via the core tube (13).

3. Coaxial bushing filter according to Claim 2,
**characterized**
**in that** the core tube (13) is insulated from the capacitor winding (5).

4. Coaxial bushing filter according to Claim 1,
**characterized**
**in that** the core tube is formed by the ferromagnetic series element formed from tubular cores (15).

5. Coaxial bushing filter according to Claim 4,
**characterized**
**in that** the ferromagnetic series element is insulated from the capacitor winding (5).

6. Coaxial bushing filter according to Claim 4 or 5,
**characterized**
**in that** contact is made between the capacitance elements and the bushing conductor (14) via metallic connecting conductors (16, 18).

7. Coaxial bushing filter according to Claim 6,
**characterized**
**in that** the connecting conductors (16, 18) are in the form of wires or striplines.

8. Coaxial bushing filter according to Claim 6 or 7,
**characterized**
**in that** the connecting conductors (16, 18) are arranged in the hole in the tubular cores.

9. Coaxial bushing filter according to Claim 6 or 7,
**characterized**
**in that** the connecting conductors (16, 18) are arranged in a separate groove (19).

10. Coaxial bushing filter according to Claim 6 or 7,
**characterized**
**in that** the connecting conductors (18), which are in the form of a stripline, are wound in between the insulation and the ferromagnetic series element.

## Revendications

1. Filtre (12) coaxial de traversée en circuit π, comprenant deux éléments (C1, C2) transversaux capacitifs et un élément (15) longitudinal ferromagnétique, dans lequel des éléments (C1, C2) capacitifs sont constitués de condensateurs (5) bobinés qui ensemble avec l'élément (15) ferromagnétique sont disposés sur un conducteur (14) de traversée, dans lequel l'élément (15) longitudinal ferromagnétique est disposé à l'intérieur du bobinage (5) du condensateur et dans lequel les condensateurs (5) bobinés présentent des couches (9, 10) frontales de contact,
**caractérisé**
**en ce que** les éléments transversaux capacitifs sont sous la forme d'un unique bobinage (5) de condensateur, constitué en condensateur double, bobinage qui est constitué d'une première (1) feuille de matière plastique déposée en phase vapeur en étant segmentée et d'une deuxième (3) feuille de matière plastique déposée en phase vapeur de manière continue à l'exception d'un bord (4) libre, en ce que la couche frontale de contact, qui contacte le dépôt constitué de segments (2) individuels, est subdivisée en deux couches (9, 10) individuelles et en ce que la couche frontale de contact, qui contacte le dépôt (6) déposé en phase vapeur de manière continue, n'est pas subdivisée.

2. Filtre coaxial de traversée suivant la revendication 1,
**caractérisé**
**en ce que** le bobinage (5) de condensateur est disposé sur un tube (13) métallique d'âme et en ce que le contact d'un condensateur partiel avec le conducteur (14) de traversée s'effectue par le tube (13) d'âme.

3. Filtre coaxial de traversée suivant la revendication 2, **caractérisé en ce que** le tube (13) d'âme est isolé vis-à-vis du bobinage (5) du condensateur.

4. Filtre coaxial de traversée suivant la revendication 1, **caractérisé en ce que** le tube d'âme est formé par l'élément longitudinal ferromagnétique constitué d'âmes (15) de tube.

5. Filtre coaxial de traversée suivant la revendication 4, **caractérisé en ce que** l'élément longitudinal ferromagnétique est isolé vis-à-vis du bobinage (5) de condensateur.

6. Filtre coaxial de traversée suivant la revendication 4 ou 5, **caractérisée en ce que** le contact des condensateurs partiels avec le conducteur (14) de traversée est obtenu par des conducteurs (16, 18) métalliques de liaison.

7. Filtre coaxial de traversée suivant la revendication 6, **caractérisé en ce que** les conducteurs (16, 18) de liaison sont constitués sous la forme de fils métalliques ou de conducteurs à ruban.

8. Filtre coaxial de traversée suivant la revendication 6 ou 7, **caractérisé en ce que** les conducteurs (16, 18) de liaison sont disposés dans les trous des âmes de tube.

9. Filtre coaxial de traversée suivant la revendication 6 ou 7, **caractérisé en ce que** les conducteurs (16, 18) de liaison sont disposés dans une gorge (19) distincte.

10. Filtre coaxial de traversée suivant la revendication 6 ou 7, **caractérisé en ce que** les conducteurs (18) de liaison constitués en lignes à ruban sont enroulés entre l'isolant et l'élément longitudinal ferromagnétique.
